# EUROPEAN PATENT SPECIFICATION

(11) **EP 0 909 343 B1**
(45) Date of publication and mention of the grant of the patent: **03.03.2004**
(21) Application number: 96922618.2
(22) Date of filing: 28.06.1996
(51) Int. Cl.: C23C 16/04, C23C 16/26, C04B 41/50, C04B 35/83, F16D 65/12

(54) **METHOD FOR REFURBISHING BRAKES**
VERFAHREN ZUR INSTANDHALTUNG VON BREMSEN
PROCEDE POUR REMETTRE A NEUF DES FREINS

(43) Date of publication of application: 21.04.1999
(73) Proprietor: Ballard Material Products, Inc., Burnaby British Columbia V5J 5J9 (CA)
(72) Inventor: SCARINGELLA, David, T., Littleton, MA 01460 (US); CONNORS, Donald, F., Jr., Nashua, NH 03060 (US); THURSTON, Garrett, S., Lowell, MA 01851 (US)
(74) Representative: Luckhurst, Anthony Henry William
(86) International application number: PCT/US1996/011100
(87) International publication number: WO 1998/000575

(56) References cited:
- EP-A- 0 592 239
- US-A- 4 472 454

## Description

Carbon-carbon composite brakes are utilized on aircraft, such as the F-15 and F-16 military aircraft, for their safety, long life, and light weight. Present aircraft brake assemblies comprise rotors and stators assembled using carbon-carbon composite disc components. It has been demonstrated that the wear life of carbon brakes can be extended by subjecting used brakes to refurbishment procedures. However, the wear life of brakes refurbished by traditional methods is only 50-80% of new brakes. While this is an improvement over discarding the worn brakes altogether, if a refurbishment procedure was available which produced densified carbon material with a wear life more closely approaching that of original brakes, significant savings in original equipment and worn brake repair costs would result.

State-of-the-art carbon-carbon densification processes, including chemical vapor infiltration (CVI) and pitch or thermoset resin impregnation low pressure infiltration, require long processing times, on the order of 25 to 50 days. Such processes have been traditionally used to densify porous carbon preforms for original equipment carbon-carbon composite brake discs as well as to refurbish worn discs. The densification must be performed slowly so that the pores on the outside of the carbon brake do not get filled before the pores on the inside of the carbon brake. If the pores on the outside of the carbon brake are blocked before densification of the interior portions, insufficient precursor reaches the inner portions of the carbon brake and it is not fully densified.

One approach to avoid this problem is revealed in U.S. patent 4,472,454 issued September 18, 1984 to Houdayer et al., which is hereby incorporated by reference. In that patent, the preform is placed in a reaction vessel and covered with a precursor liquid. A coil outside of the reaction vessel is used to inductively heat the preform. The preform is heated hot enough to boil the liquid precursor and pyrolyze the vapor generated when the liquid boils. We theorize that the liquid cools the preform at its exterior, thereby creating a thermal gradient through the thickness of the preform. The interior of the preform, since it is not cooled by the boiling liquid, is hot enough to pyrolyze the vapor. In this way densification occurs preferentially at the interior of the preform. The overall densification occurs from the inside outward. Densification can, thus, be performed at a higher rate without concern that the pores at the exterior will be blocked and prevent densification of the preform interior.

While the densification process as described in U.S. 4,472,454 reduces the time needed to densify a preform, we have discovered several ways in which the process could be improved.

First, in densifying a preform, it is desirable to have the induction coil conform to the shape of the preform. It is also desirable to have the preform as close as possible to the induction coil..These requirements are important to provide uniform and efficient heating of the preform. Uniform heating is important to provide a desirable densification.

To adjust the apparatus of Houdayer et al. to meet these requirements entails reshaping the coil based on the shape of the part to be densified. It also entails reshaping the reaction vessel and coil for each part. Such a requirement is undesirable because it can be costly or time consuming. Moreover, we have discovered that cooling due to the boiling of the liquid, which is needed to create the desired temperature gradient, does not occur if the reaction vessel is too close to the preform. If walls of the reaction vessel are too close to the preform, a phenomenon called "vapor lock" can occur. In vapor lock, vapor builds up at some point between the wall of the reactor vessel and the preform, displacing the liquid. Convective heat transfer away from the preform is greatly reduced at that point, creating a hot spot and causing formation of deposits on the outside of the preform. As a result, the part is non-uniformly densified.

The method of refurbishing carbon-carbon composite brakes for aircraft disclosed herein will significantly reduce processing time, e.g., to 48 hours or less, and as a result, produce cost effective carbon-carbon components. In particular, this process is of interest for the fabrication of carbon aircraft brakes and the redensification or refurbishment of these brakes. Further, this chemical vapor deposition (CVD) process yields a densified carbon structure having a density similar to original equipment brake component(s) or refurbished brake component(s) approved for use in aircraft, i.e., at least 1.85 g/cc, preferably 1.9 g/cc in the deposited carbon matrix, and an appropriate CVD microstructure for a friction material which is a substantially non-isotropic microstructure. Such structural characteristics are needed to obtain the frictional wear characteristics appropriate for carbon aircraft brake components.

EP-A-592 239 describes a method and apparatus for densification of porous billets, by which the billet is inductively or resistively heated in a liquid carbon-precursor to cause rapid chemical vapor deposition in the interior of the billet to densify it.

### Summary Of The Invention

This invention provides :
1. A chemical vapor deposition method for refurbishing worn carbon brake component(s) for aircraft, comprising the steps:
   a) placing at least one worn carbon brake component(s), having pores defined by interior regions, including at least one geometric center region, and an exterior surface, in a liquid carbon-precursor contained within a reactor for densifying a porous structure, the reactor being adapted to contain the liquid carbon-precursor and to contain at least one internal induction coil; and
   b) inductively heating the interior regions of the worn carbon brake component(s) to a temperature above the decomposition temperature of the liquid carbon-precursor, thereby effecting formation of a vapor from the liquid carbon-precursor and infiltration into the interior regions of the vapor and deposition of pyrolytic carbon within the interior regions until the worn carbon brake component has a density of at least 1.85 g/cc and a non-isotropic CVD microstructure, and wherein the inductively heating step may be continuous or interrupted by periodic cooling by at least 10°C.

This invention also provides a chemical vapor deposition method of resistively heating carbon brakes according to claim 12 to refurbish carbon lost during wear and methods of refurbishment combining resistive and inductive heating. For some brakes, these chemical vapor deposition methods may be completed in two to three and one- half hours at about 950 to 1100°C at atmospheric pressure using cyclohexane precursor. A density of at least 1.85 g/cc and preferably 1.9 g/cc in the deposited matrices and a non-isotropic CVD microstructure, may be achieved in refurbished carbon brake component(s) in process runs completed in 48 hours, preferably in 24 hours, or less.

### Brief Description Of The Drawings

The invention will be better understood by reference to the following detailed description and accompanying drawings in which
FIG. 1 is a schematic of a reactor for densifying preforms;
FIG. 2A is a sketch of a fixture used to hold a preform in the reactor of FIG. 1;
FIG. 2B is a schematic of a coil as used in the reactor of FIG. 1;
FIG. 3 is a sketch of a preform heated with an alternative coil configuration;
FIG. 4 is a sketch of a preform heated resistively;
FIG. 5 is a sketch of a preform heated both inductively and resistively;
FIG. 6 is a sketch of a preform heated with an alternative coil configuration;
FIG. 7 is a graph of densification profiles at various power levels; and
FIG. 8 is a representative graph of input power to the coil in the reactor vessel versus time.

### Description Of The Preferred Embodiment

Aircraft carbon brakes suitable for refurbishment include multiple disc friction brakes comprising a plurality of carbon-carbon rotor discs interleaved with a plurality of carbon-carbon stator discs. Worn carbon brake pressure plates and end plates also may be refurbished.

Any worn carbon surfaces of aircraft brakes may be refurbished by the method of this invention. Suitable aircraft brakes are known to those skilled in the art, and include, but are not limited to, those disclosed in U.S. Pat. Nos. 3,934,686, issued January 27, 1976, to Stimson, et al.; 4,613,021, issued September 23, 1986, to Lacombe, et al.; 4,465,165 issued August 14, 1984, to Bok; 4,511,021, issued April 16, 1985 to Grider, 4,804,071, issued February 14, 1989; to Schultz, et al., 4,982,818, issued January 8, 1991, to Pigford; and 5,143,184 issued September 1, 1992, to Snyder, et al., which are hereby incorporated by reference.

Worn carbon rotor and stator discs may be refurbished by removing them from the brake assemblies and grinding them to one-half of their original thickness. The ground discs may be densified by the chemical vapor deposition method herein to restore original density and wear properties, or two ground discs may be used in place of one original disc when the brakes are reassembled. Optionally, the ground discs may be bonded together. One such technique for bonding two worn discs to create one refurbished disc is disclosed in U.S. Pat. No. 4,465,165, issued to Pigford August 14, 1984. Following refurbishment, carbon discs may be treated with protective materials such as are disclosed in U.S. Pat. No. 4,837,073 issued June 6, 1989 to McAllister, et al., to protect against oxidation.

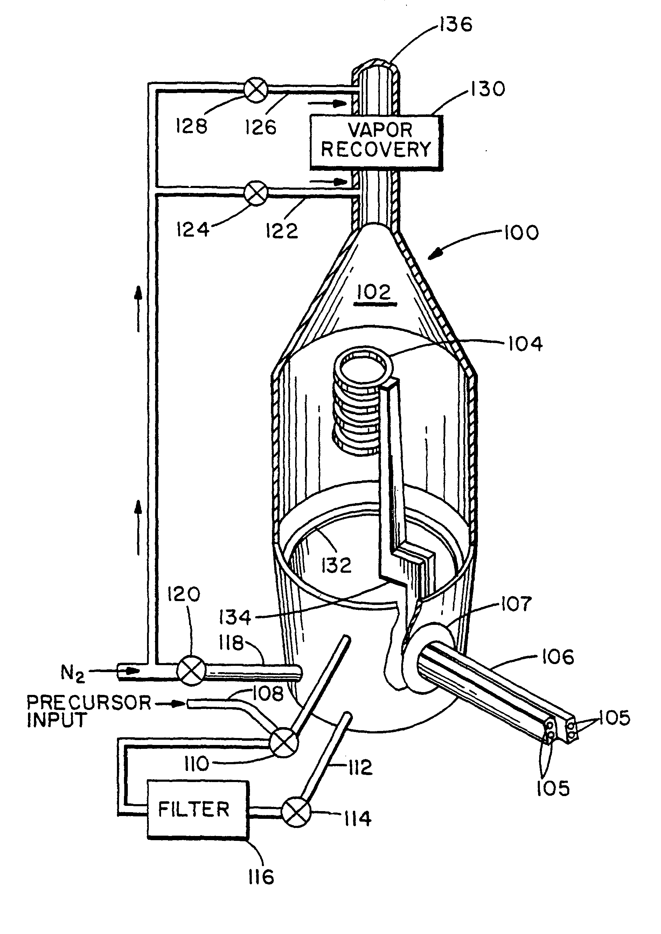

FIG. 1 shows a reactor 100 suitable for performing rapid densification according to the method described in U.S. patent 4,472,454. When an induction coil, such as coil 104, is used to heat a preform, reactor 100 is preferably made from nonmagnetic materials such as quartz, glass, aluminum, stainless steel, ceramic, PMC or combinations thereof.

Reactor 100 contains a cavity 102 in which a preform (not shown) is densified. In operation, cavity 102 is filled with a precursor liquid sufficient to at least cover the preform (not shown). The precursor liquid is any liquid which will boil and create a vapor containing chemicals that will deposit at a temperature to which the preform (not shown) can be heated. The precursor liquid should also be a dielectric. Preferably, the dielectric constant of the reagent liquid should be above 0.5, more preferably above 1, and most preferably above 1.5. To deposit carbon on the preform, a hydrocarbon with appropriate boiling point such as cyclopentane, cyclohexene, hexene-1, gasoline, toluene, methycyclohexane, cyclohexane, n-hexane or benzene, or a combination thereof could be used.

Within cavity 102, an induction coil 104 is positioned. In operation, induction coil 104 will be covered by the precursor liquid and operate to heat the preform (not shown). Coil 104 is made from copper or other highly conductive material which does not react with the precursor liquid even if heated.

Electricity is provided to coil 104 through busses 106. Busses 106 are made of a highly conductive material, here copper. Currents of hundreds of amperes to thousands of amperes are preferably used to provide sufficient power to heat the preform (not shown). Because of the large amount of current, busses 106 must have sufficient cross section to avoid excess heating. Busses 106 may contain water passages 105 to carry cooling water through busses 106 and through coil 104.

Busses (106) are connected to a power supply (not shown). An AC supply is used. The voltage, current, frequency and shape of coil 104 are determined by the shape and geometry of the preform as well as preform properties using known techniques used to design induction heating apparatus. Typically, the voltage will be in the range from 5 to 750V. The frequency will be in the range of 0.1KHz to 300MHz.

Busses 106 pass through seal 107 to enter chamber 102. As chamber 102 contains a precursor liquid during operation, seal 107 must be resilient and also resistant to chemical attack by the precursor liquid. It should also electrically insulate busses 106 from reactor 100 in the event reactor 100 is formed from conducting components. For example, silicone rubber could be used to seal the opening in reactor 100 through which busses 106 pass.

It is a matter of convenience that busses 106 enter the lower portion of reactor 100. If busses 106 entered the upper position of reactor chamber 102, seal 107 would still be needed. It would not have to prevent the escape of liquid, but it would have to prevent the escape of vapor from chamber 102. Busses 106 could even enter chamber 102 by moving down stack 136, in which case no special seal would be needed. However, it is desirable to keep busses 106 as short as possible to reduce power loss in the busses.

Precursor liquid is supplied to reactor 100 through precursor input 108 via valve 110.

Initially, chamber 102 is filled with precursor liquid at least of sufficient quantity to cover the preform (not shown). In operation, precursor liquid may be consumed in the deposition reaction or escape from reactor 100 as vapor. Accordingly, precursor input 108 may be utilized during operation of reactor 100 to replace precursor liquid which is dissipated.

During a densification operation, the liquid precursor may become clouded. Accordingly, valve 114 may be opened to allow precursor liquid to flow through reagent return 112 to filter 116 where it is filtered and pumped back into reactor 100. Filter 116 may be any suitable filter such as a porous ceramic screen or, more preferably, charcoal.

The reagent liquids as used herein are potentially inflammable. Accordingly, it is preferable that the densification operation be performed in an inert atmosphere. For example, nitrogen gas may be used. To purge cavity 102 of air, valve 120 is opened to allow nitrogen to flow through input 118. Valve 124 may be opened to more rapidly and effectively purge vapor recovery system 130. Once the atmosphere in chamber 102 is replaced by nitrogen, valve 128 may be opened to provide nitrogen directly into vent stack 136. This flow of nitrogen will prevent air from reaching cavity 102 and valves 120 and 124 may be closed. Closing valves 120 and 124 reduces the flow of gas through vapor recovery system 130. Vapor recovery system 130 may therefore operate more efficiently.

Vapor recovery system 130 is a system of the type known in the art for recovering vaporized liquids. Such a system will reduce the amount of waste generated in the process and the amount of precursor used.

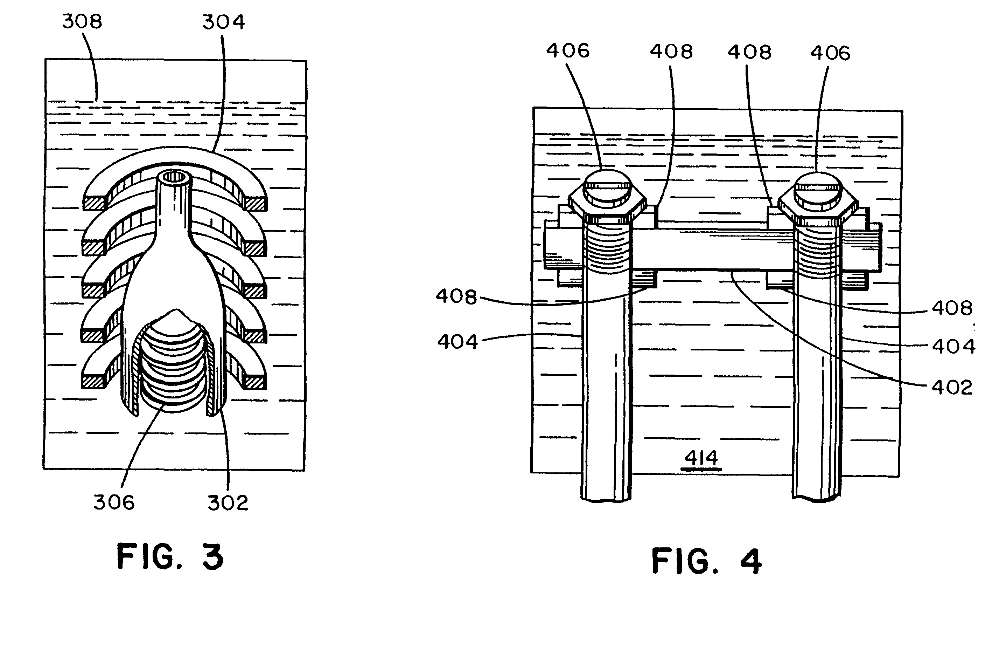

In operation, a carbon brake (not shown) is placed in cavity 102 in close proximity to coil 104. Example coil locations are shown in more detail in FIGs. 3, 5, and 6. The carbon brake is preferably placed in a support fixture to firmly hold the carbon brake at a constant position in relation to the reactor and coil. The exact shape of the fixture is based on the shape of the carbon brake. Such a fixture could be supported in any convenient way, such as on lip 132.

It may be desirable to use different sizes or shapes of coils based on the shape of the carbon brake. For this reason, coil 104 is connected to busses 106 at connector 134. Connector 134 continues the electrical circuit comprising busses 106. It also continues the water flow circuit formed by channels 105. Connector 134 may simply be a block of metal allowing anchoring points for screws (not shown) to hold the base of coil 104 to busses 106. The joints in the water flow circuit could be sealed by flexible "O" rings or in some other convenient fashion. The material must be resistant to degradation in both water and the precursor liquid. Viton or silicone rubber may be used for this purpose. Other attachment arrangements, such as slots and grooves or clips, could also be used.

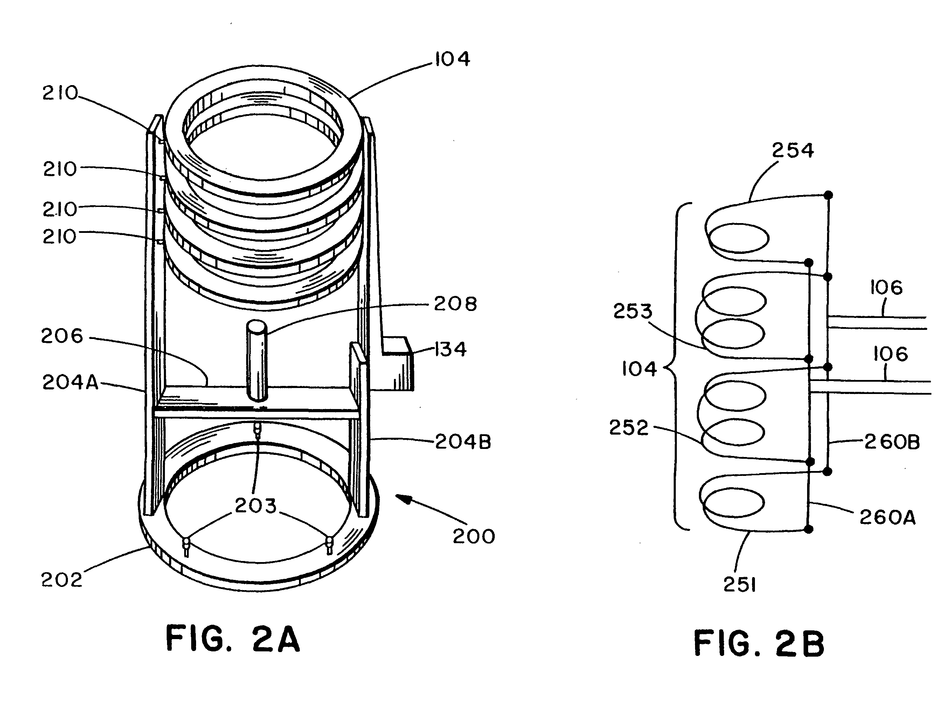

FIG. 2A shows a sketch of a mounting fixture 200 for use in conjunction with the reactor of FIG. 1. Fixture 200 contains a ring 202 of appropriate size to seat on lip 132 (FIG. 1). Screws 203 pass through ring 202. Screws 203 may be screwed into lip 132 (FIG. 1) to attach fixture 200 to reactor 100 (FIG. 1). Alternatively, screws 203 may just rest on lip 132 (FIG. 1). In this way, screws 203 act to adjust the vertical angle of fixture 200 relative to lip 132 (FIG. 1).

Being able to adjust the vertical angle of fixture 200 can be useful if coil 104 is fixedly attached to reactor 100 (FIG.1). As fixture 200 holds a carbon brake, adjusting the vertical angle of fixture 200 will also adjust the position of the carbon brake relative to coil 104. As it is preferable that the carbon brake be positioned so as to be concentric with the coil, being able to adjust either the location of the carbon brake or the coil is desirable.

Fixture 200 comprises vertical members 204A and 204B. A horizontal member 206 spans vertical members 204A and 204B. A post 208 is attached to horizontal member 206. A carbon brake is attached to post 208 in any convenient way. For example, if the carbon brake is arranged around a mandrel, a pin through the mandrel might be inserted into post 108. As horizontal members 204A and 204B, vertical member 206 and post 208 will be in close proximity to induction coil 104, it is preferable that they be made of nonmagnetic material (having a magnetic permeability of approximately 1). They should, however, be of a material strong enough to provide support to the carbon brake. Glass epoxy composite could be used. As post 208 may be in contact with a carbon brake which is heated, it should be made of a material which is a good thermal insulator and can withstand high temperatures. Post 208 is more preferably made from quartz.

To ensure the proper relationship between a carbon brake and coil 104, it may be desirable to secure coil 104 directly to fixture 200. Coil 104 could then be secured to vertical member 204 with non-conducting pins 210.

FIG. 2B shows coil 104 in greater detail. Optionally, coil 104 is made of a plurality of coil segments 251, 252, 253, and 254 electrically connected in parallel. Coil segments 251-254 are connected to conducting rods 260A and 260B. Busses 106, which supply power to coil 104 are connected to conducting rods 260A and 260B. As shown in FIG. 2B, busses 106 are connected to the center of conducting rods 260A and 260B. Coil segments 251-254 are thus symmetrically disposed around the source of power. As a result, any voltage drops, which may be significant when large currents are used, are averaged out along the length of coil 104. More uniform heating of a carbon brake thus results.

To provide more uniform heating, the length of each coil segment may optionally be different. For example, since coil segments 252 and 253 are closer to the power feed from busses 106, they could be made longer, such as by having more turns, than coil segments 251 and 254. Coil segments 252 and 253 could be sized such that the resistance in the circuit from busses 106 through any coil segment 251-254 is identical.

Coil 104 may optionally be designed to have non-uniform turn density along its length to account for gravity effects on the process. For example, vapor generated by the boiling precursor liquid will rise along the carbon brake. It is possible that the amount as well as the velocity of the vapor will be greater at the top of the carbon brake than at the bottom. As a result, heat transfer out of the carbon brake may be different at the top than at the bottom. To counter this effect, it is possible to structure coil 104 to provide different heating at the top of the carbon brake. For example, the turn density of the coil could be less at the top or the spacing between the coil and the carbon brake could be less at the top.

FIG. 3 shows the relationship of a preform 302 to a coil 304 inside a reactor 300. Preform 302 is in the center of coil 304 and both are immersed in a precursor liquid 308.

For induction heating applications, the coil is generally shaped to conform to the part to be heated. The diameter of the coil might be smaller where the diameter of the part is smaller. Alternatively, the turn density of the coil can be increased in areas where the object to be heated is further from the coil.

Coil 304 could be shaped to conform to preform 302. Alternatively, a second coil, coil 306, may be inserted inside preform 302. The current flow through each coil should be such that the magnetic flux generated by each coil are in phase in preform 302. Preferably, both coil 304 and 306 are connected to the same power supply to ensure that the currents through them are in phase. The arrangement of FIG. 3 is, of course, only useful for hollow preforms. With both coils 304 and 306 in place, the magnetic flux is more uniform throughout preform 302. Regions of preform 302 which are further from coil 304 and thus not effectively heated by coil 304 are closer to coil 306 and more effectively heated by it. In this way, uniform preform heating may be achieved without specifically engineering a coil for each preform.

FIG. 4 shows an alternative method of heating preform 402. Here, preform 402 is in the shape of a bar or a rod. Preform 402 is clamped between electrodes 404. Preform 402 is clamped in any convenient means to provide good electrical and mechanical connections.

Electrodes 404 are made from any convenient material which can carry the current required to densify the part without heating significantly or reacting with the precursor liquid.

Here, electrodes 404 are made from 1.9 cm (three quarter inch) copper rods which have slits 406 formed in them. Copper shims 408 are placed in the slot around preform 402. The shims 408 are pressed into preform 402 by bolts-410 tightened onto threaded ends 412 of electrodes 404.

In operation, preform 402 is placed in a precursor liquid 414. Electrodes 404 are connected to a power supply (not shown) which provides a current flow through preform 402 which heats preform 402. When the resistance of the preform is low, such as when the preform is made of carbon fiber or is made of some fiber held together by a carbonized resin, a high current supply is preferable. The amount of current needed will depend on the cross sectional area of preform 402 as well as its resistivity. However, the current should be sufficient to heat some part of preform 402 above the pyrolysis temperature of precursor liquid 414. Currents on the order of 1,000 amperes are likely to be needed, though the exact current level may be set empirically based on temperature measurements of the preform. Direct current is preferable, but AC current might also be used. It may also be necessary to change the current as the densification of preform 402 proceeds. As preform 402 becomes more dense, its resistance is likely to decrease, requiring an increase in current to maintain the same level of heating. For that reason, it may be preferable to use a pyrometer to continuously or periodically measure the temperature of the preform and then adjust either the voltage of the supply to keep the desired current or to adjust the current directly.

The apparatus of FIG. 4 is particularly suitable for densifying preforms in shapes with uniform cross sections, such as bars or rods or tubes with uniform diameter and wall thickness, flat plates, or other shapes with a uniform cross sectional area perpendicular to the direction of current flow. Such preforms may be in the finished, or "net" shape. Alternatively, disks or other shapes may be cut out of the rod, bar, flat plates or other shapes after densification. In this way, parts with non-uniform cross sections may be densified. Alternatively, several parts may be cut out of one densified piece, effectively allowing several parts to be densified simultaneously in one reactor with only one power supply.

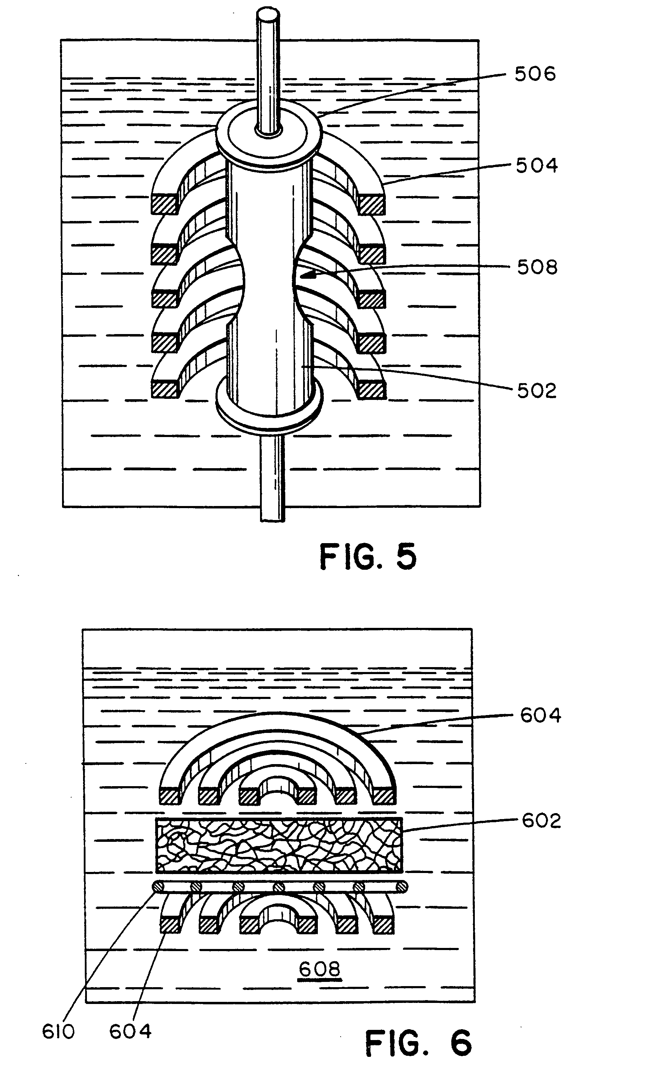

FIG. 4 shows preform 402 oriented horizontally in a reactor vessel. Any orientation could be used. FIG. 5 shows an alternative configuration for densifying a preform 502. Preform 502 is placed inside an induction coil 504. The ends of preform 502 are coupled to electrodes 506. When coupled to appropriate power supplies as described above, coil 504 provides induction heating of preform 502 and electrodes 506 facilitate resistive heating.

Preform 502 contains a concave region 508. For uniform heating using resistive heating, preforms with concave regions or regions of nonuniform cross section are generally undesirable as the current density and hence the heating, increases in concave regions. Likewise, concave regions are detrimental to uniform heating using inductive heating since, without a special coil design, concave regions are not heated as well as surrounding areas. However, using both resistive and inductive heating tends to provide more uniform heating since hot spots associated with resistive heating tend to be canceled by cold spots of inductive heating. Accordingly, it is possible to uniformly heat preform 502 without a special coil design to conform to the contours of preform 502.

The combination of resistive and inductive heating also provides an advantage in allowing better control of preform heating. For the preform to densify most fully, it is desirable that the center of the preform initially be heated above the pyrolysis temperature of the precursor liquid. A temperature gradient is established decreasing from the center of the preform to the periphery due to the cooling effect of the precursor liquid. With this temperature distribution, deposition of densifying material preferentially occurs at the center of the preform. As densification proceeds, it is desirable that regions of the preform moving successively radially outward from the center exceed the pyrolysis temperature. Resistive heating generates heat nearly uniformly across the cross section with only second order differences due to the change in resistivity due to the temperature gradient. With the precursor liquid cooling the exterior of the preform, the resulting temperature profile is hottest in the center and coolest at the edge. Additionally, for some preforms, the resistance will drop with increased temperature such that current, and hence additional heat generation, will be concentrated at the hotter interior portions of the preform. This temperature distribution is well suited for the start of the densification cycle.

Conversely, induction coil 504 causes heat to be generated in greater amounts near the periphery of the preform. The amount of heat generated drops to 14% of its maximum value at the skin depth. The skin depth is in turn a function of frequency, decreasing in inverse proportion to the square root of the frequency. By appropriately selecting frequency using known techniques familiar to those skilled in the art of induction heating, induction coil 504 may provide greater heating at the periphery of the preform. This heat distribution is desirable at the end of the densification cycle. Accordingly, desirable results can be achieved by initially heating preform 502 resistively and then increasing the current through coil 504. Current through electrodes 506 could be simultaneously decreased if desired.

A similar heat distribution during the densification cycle could also be obtained by an induction coil above. The frequency of the power supply is initially set to provide a skin depth of roughly one quarter to one third the diameter of the preform. This skin depth, taking into account heat transfer out of the preform, will provide maximum heat accumulation at the center of the preform. Ideally, the power in the coil will be set to heat the preform to slightly above the pyrolysis temperature of the precursor liquid while the precursor liquid cools the remainder of the preform to be below the pyrolysis temperature. As the center of the preform densifies, the frequency of the power supply can be increased to heat the preform to slightly above the pyrolysis temperature in regions slightly displaced from the center. Also, the power supplied in the coil may be slightly reduced to ensure that the remainder of the preform remains below the pyrolysis temperature of the precursor liquid. Adjustments can be made in this fashion until the preform is fully densified. The exact rate of change of frequency and power will depend on the shape and composition of the preform and may need to be determined empirically.

Even if an induction coil is used without a resistive source, a desirable result may be obtained by increasing the power to the induction coil as the densification cycle proceeds.

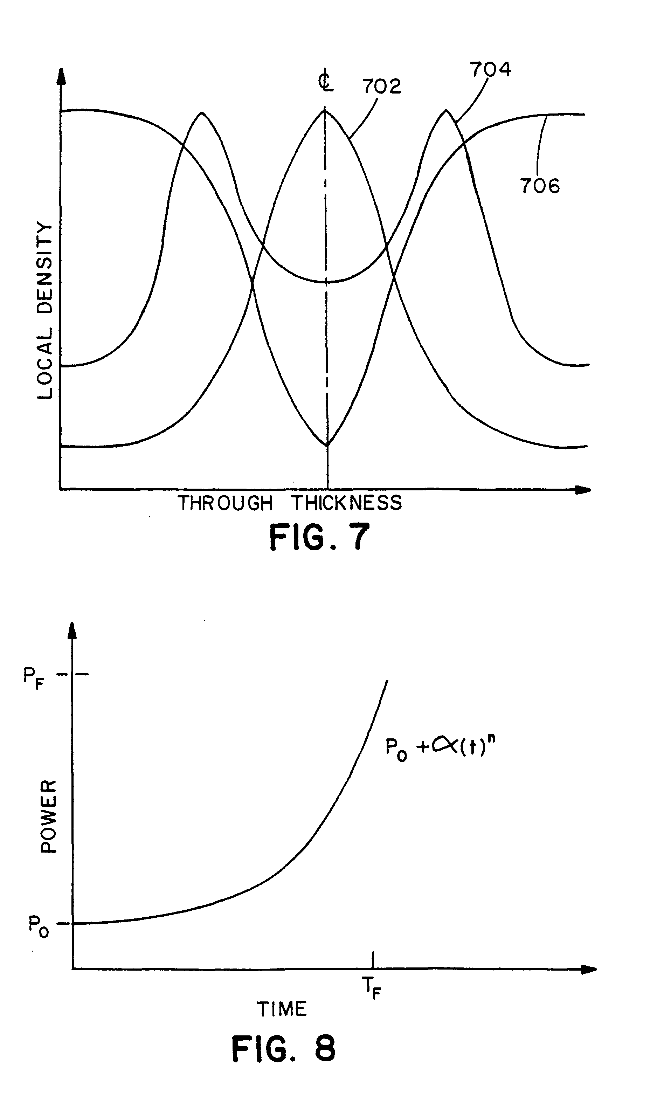

FIG. 7 shows three curves useful in understanding how increasing power during the densification cycle can provide more complete densification. FIG. 7 shows curves 702, 704, and 706, each of which shows the density of a densified preform as a function of distance from the center of the preform thickness. Curve 702 is made at a relatively low input power. The density is a maximum at the centerline. This densification pattern results because the center heats to a temperature sufficient to cause pyrolysis of the precursor liquid. The outside of the preform is cooled such that no pyrolysis and associated deposition reactions result. Curve 706 is made at a relatively high input power. Maximum density occurs at the periphery because the periphery heats to a temperature high enough to cause pyrolysis of the precursor. Pyrolysis causes deposits which block the infiltration of the precursors into the center of the preform. Curve 704 is made at an intermediate power and shows a maximum density intermediate the centerline and the periphery.

To provide improved densification, it is desirable to initially use a power Pₒ, such as was used to create curve 702. At the end of the densification cycle, it is preferable to use a power, P_{f}, such as was used to create curve 706. In between, it is better to use a power which gives a curve such as 704. FIG. 8 shows a curve of desirable levels of input power as a function of time, P(t), during the densification cycle. The power is initially set at Pₒ. At the end of the densification cycle at time T_{f}, the power equals P_{f}. During the densification cycle, the power is increased. As shown in FIG. 8, the power is increased in proportion to time, t, raised to the power n. This relationship is desirable because the chemical reaction which causes deposits increases with increasing temperature. Thus, less time is needed to densify the outer portions of preform. Also, the other portions of the preform densify to some extent while the interior is being densified. As a result, the peripheral portions of the preform densify much faster than the interior and less time is needed to densify the outer portions of the preform.

The values of µ, Pₒ, P_{f}, T_{f}, and n depend on such things as preform size and geometry as well as on the specific precursor liquid used. It is possible to theoretically calculate those values. However, due to the complicated nature of the phenomena involved, it can be preferable to empirically determine appropriate values. Several trial runs, stopped periodically to observe the preform and measure its density, may be necessary to determine appropriate values. Values of n in the range of 1 to 5 have been observed to be satisfactory for carbon brake component(s) as shown herein. However, other values may be desirable for other geometries.

It should be noted that FIG. 8 shows a continuous change in power. The power may, however, be increased in discrete steps. Also, the same pattern of varying input power may be used regardless of the method of heating the preform. Further, the curve of FIG. 8 shows that the power is continually applied. As described hereafter, it may be beneficial to periodically pulse the applied power between an "on" state and "off" state or a reduced level. If a pulsed power source is used, the curve of FIG. 8 represents the power in the "on" state.

A further way of controlling the deposition is to adjust the pressure in the reactor chamber. Initially, it is desirable to cool the periphery of the preform so that deposition occurs principally at the interior. Cooling occurs by boiling or vaporization and convection of the precursor liquid, in addition to radiative heat transfer. Once the center of the preform has been densified, less cooling of the periphery is desirable so that densification of the exterior of the preform will densify rapidly. To reduce the cooling, the pressure of the reactor chamber may be altered. For example, the pressure might be simply increased by choking off vent stack 136.

As described above, it is desirable to have densification occur preferentially at the interior of the preform. The foregoing process control techniques relate to controlling a densification process by controlling heating of the preform. It is also possible to control the diffusion of vapor into the preform.

If more vapor reaches the interior portions of the preform or the concentrations of vapor in the interior of the preform increases, densification will occur preferentially at the interior of the preform.

One way to increase the concentration of materials which will form a deposit in the interior of the preform is to pulse the heating of the preform. Pulsing the heating allows by-products generated when the vapor forms a deposit to diffuse out of the preform when no heating is occurring or heating is reduced. For example, if cyclohexane is used as a precursor liquid, H₂ is generated as a by-product. If the power to the coil (when induction heating is used) or the power to the preform (when resistive heating is used) is periodically interrupted for a period long enough to allow H₂ to diffuse out of the preform, when heating is resumed, more cyclohexane vapor can diffuse into the preform. The concentration of the cyclohexane vapor will then be higher because the H₂ has dissipated.

The heating needs to be interrupted for a relatively short period of time. The length of time depends on the size of the preform and also the stage of densification. It might take longer for the by-products to diffuse out of the center of a thick preform then out of the edges. As a result, it may be desirable to interrupt the heating for longer periods of time during the early parts of the densification cycle when the interior of the preform is densifying. Heating, preferably, should be interrupted for a period of between 0.01 seconds and 10 minutes, more preferably 0.01 to 3 minutes. Heating should be interrupted at intervals of a length inversely proportional to the rate at which the by-products are generated, preferably between about 0.01 seconds and 3 minutes.

Interrupting the heating also provides an additional advantage of making a stronger finished part. The strength of the densified part is due in part to the strength of the deposited material. The strength of the deposited material is in turn dictated by its microstructure. As the material is deposited, crystalline domains grow. The part is stronger though, if all the domains are small. Interrupting heating long enough for the part to cool to a temperature which would cause renucleation, results in smaller domains. Domains smaller than the diameter of the fiber used to make the preform, typically below 5 microns, are considered small.

The heating should be applied to the perform for the time it takes the domain to grow to the desired size. Times of approximately 0.1 seconds to 5 minutes are typical. The heating should than be interrupted for long enough for the preform to cool below the renucleation temperature. Times of 0.01 seconds to 10 seconds are typical. Since the deposition is exponentially dependent on temperature, cooling of as little as 10 to 200°C may be sufficient to cause renucleation.

Controlling the grain size is also important in making friction material, such as is used in brakes. Smaller domains may lead to a different coefficient of friction than larger domains. Controlling the domain size thus allows the materials within the desired coefficient of friction to be made.

It should be noted that the pulses need not be of constant duty cycle or occur at constant intervals. For example, as shown in FIG. 8, the power level may change during the densification cycle. The pulse characteristics might be changed with the power level.

An alternative way to increase the deposition of material in the interior of the preform is through the use of pressure waves in the liquid precursor. These waves are accentuated in the vapor as density waves which force precursor into the part and draw by-products out. In the system as described above, pressure waves exist in the liquid due to generation and contraction of bubbles associated with boiling the liquid precursor. The magnitude of the waves could be increased by cooling either the precursor liquid or the exterior of the reaction vessel. For example, in FIG. 1 filter 116 could contain a refrigeration section to cool the liquid. Alternatively, reactor 100 could be jacketed by water or some other cooling mechanism.

An alternative approach to generating pressure waves in the precursor liquid is to place one or more transducers in the precursor liquid. An acoustic or ultrasonic transducer could be used. The transducer could be pulsed to generate waves in the precursor liquid. Mechanical agitation or stirring of either the preform or precursor liquid could also be used.

FIG. 6 shows an alternative coil arrangement preferred for densifying and refurbishing brake discs. Here, a disk shaped preform 602 is placed between "pancake" coils 604. Pancake coils 604 will provide a more effective heating in the center of some preforms, such as preform 602, than would a coil shaped, for example, as coil 304 (FIG. 3). Pancake coils are also useful for preforms in which the through-the-thickness resistivity is high or for heating preforms which contain edges which would be along the axis of a coil such as coil 104 (FIG. 1).

FIG. 6 shows pancake coils 604 to have uniform spacing between successive turns. Nonuniform spacing may be desirable in some instances. For example, if preform 602 is a disk with a hole in its center, the turn density might be increased in the region halfway between the outside of the preform and the outside of the hole in the center of the preform. Design techniques conventionally used for induction heating systems are preferably employed.

FIG. 6 shows preform 602 resting on an open mesh 610. Open mesh 610 or other similar support structure holds preform 602 while still allowing precursor liquid 608 to reach the under surface preform 602. Generally, preforms for carbon-carbon composites are made of fibers held together by resin or pitch. The resin or pitch is then heated to a high temperature, converting it to carbon. The carbon is still porous and must still be densified. However, the preform is generally fairly rigid and many ways of supporting the preform are possible. According to the invention a worn carbon brake component is provided in place of preform 602.

The preform of FIG. 6 is called a dry preform because it is not held together by carbonized resin or pitch. One type of dry preform is a "needled" preform, which is made by stacking up layers of fibers and poking barbed needles through the stack. The needles drag fibers through the layers locking the layers together. The resulting preform is less rigid and may need to be supported throughout its length on a structure such as a frame or mesh 610.

Dry preforms also have a higher resistivity than a preform held together with resin or pitch, thus, a higher frequency to is required heat these materials efficiently. As the preform begins to densify, the frequency may need to be decreased to compensate for the decrease in resistivity. Similar adjustments may be needed for resistive heating. The current may need to be increased to compensate for the decreased resistance.

For some preforms, very high frequencies will be needed to provide effective induction heating. Resistive heating as described herein could be used. Alternatively, high frequency energy can be generated from a microwave source rather than an induction coil. If microwaves are to be used, the reactor vessel should be made from a material which reflects microwave energy and shaped like a cavity used in a microwave furnace. Where necessary, openings in the reactor vessel must be smaller than one quarter wave length of the frequency used or covered with a conductive mesh having openings less than one quarter wavelength. Frequencies in the range of 300MHz to 300GHz could be used, more preferably, frequencies in a range of 915MHz to 2.45GHz could be used.

Flux concentrators could be used in conjunction with induction coils as described herein. For example, FIG. 6 shows a pancake coil, which produces a symmetrical field pattern. Flux concentrators such as ferrite balls or the commercial product Fluxtrol flux concentrator sold by the Fluxtrol Company could be used. The flux concentrator might, for example, be placed on the outside portions of the coil away from the preform to direct more of the generated flux towards the preform.

### EXAMPLE 1

F-16 aircraft brakes were disassembled and worn carbon rotor discs were ground to yield a half-thickness rotor from each rotor disc. The rotors were 12 inch (30.5cm) diameter carbon-carbon annular discs which had been used in actual aircraft operation for normal brake life-cycles.

Three rotors (Disc # 2,3 and 4) were densified separately under run conditions similar to those set forth below for rotor disc #3. Each rotor was immersed in cyclohexane contained in a reactor of the type shown in FIGs. 1 and 6. At the conclusion of densification the bulk density of the rotor was approximately equal to that of the original equipment carbon brake rotor.

**Table I**

| Run Conditions: Densification of Carbon Brake Rotor Disc #3 | | | |
|---|---|---|---|
| Elapsed Time of run Hours: Minutes | Voltage^{a} | Power^{b} | Frequency^{c} |
| | Volts | Kwatts | KHz |
| 0 | 232.00 | 28.50 | 15.75 |
| 0:10 | 244.00 | 30.00 | 16.00 |
| 0:20 | 256.00 | 31.50 | 16.25 |
| 0:30 | 260.00 | 33.00 | 16.75 |
| 0:40 | 276.00 | 35.25 | 17.00 |
| 0:50 | 284.00 | 37.50 | 17.25 |
| 1:00 | 288.00 | 39.00 | 17.50 |
| 1:10 | 296.00 | 41.10 | 17.63 |
| 1:20 | 308.00 | 43.50 | 17.75 |
| 1:30 | 312.00 | 45.00 | 18.00 |
| 1:40 | 320.00 | 46.80 | 18.13 |
| 1:50 | 328.00 | 48.75 | 18.25 |
| 2:00 | 332.00 | 51.00 | 18.50 |
| 2:10 | 336.00 | 52.50 | 18.75 |
| 2:20 | 344.00 | 54.45 | 19.00 |
| 2:30 | 352.00 | 56.40 | 19.25 |
| 2:40 | 356.00 | 58.50 | 19.25 |
| 2:50 | 360.00 | 60.30 | 19.38 |
| 3:00 | 372.00 | 62.10 | 19.50 |
| 3:10 | 376.00 | 64.05 | 19.75 |
| 3:20 | End of Run | | |

| | | | |
|---|---|---|---|
| a. Full scale voltage on power supply used for runs was 800 volts. | | | |
| b. Full scale power on power supply used for runs was 150 Kilowatts. | | | |
| c. Full scale frequency on power supply used for runs was 25 Kilohertz. | | | |

The surface temperature of the carbon brake rotor disc was estimated to be approximately 800-1,100°C during the densification runs. It was generally observed that heating to an internal temperature of 950 to 1100°C for 2.0 to 3.5 hours in cyclohexane was sufficient to refurbish worn carbon brake components to a density at least equal to that of an original equipment, or a traditionally refurbished, carbon brake component of equivalent size, density and composition which is in use in aircraft operation.

Following densification, samples of the densified rotors were subjected to post-heat treatment for 2 hours under an argon atmosphere at temperatures of 1800, 2100 and 2400°C.

Subscale test specimens (1.25 inch outer diameter; 0.85 inner diameter) were machined from fixed points in each rotor and an anti-oxidant paint was applied to the inner and outer edges of the test specimens prior to wear and friction testing.

### Example 2

To simulate wear and performance during landing conditions for F-16 aircraft (a 210 knot landing) a testing apparatus in use at Composite Testing and Analysis, University of Michigan, was set to the following parameters:
rotational speed of specimens: 116 kg. (257 lbs)
normal force applied to disc at full speed: 31,500 rpm (pressure on disc surface: 24 atm. (390 psi)

These parameters yielded a model which simulated the following maximum conditions occurring during landing of an F-16 aircraft:
maximum velocity of the braking surface: 53.7 m/sec (2114 in/sec)
maximum contact pressure between brake discs: 24 atm. (390 psi)
maximum temperature for braking surface at zero velocity: 815°C

Rotor specimens were tested for ten cycles and wear measurements were taken. Coefficient of friction calculations were made using data collected only on the last five cycles to avoid surface imperfection effects. Results shown below are compared to data collected on new brake and worn brake control specimens. The "worn" brake specimens are representative of traditionally refurbished worn brakes, i.e., two worn discs are ground down and used in place of one original equipment brake disc. x

**Table 2**

| **WEAR RESULTS AFTER TEN BRAKING CYCLES** | | |
|---|---|---|
| **Rotor Specimen** | **Specimen Type** | **Sample Wear (mm)** |
| New - 1a | New | 0.06 |
| New - 1b | New | 0.07 |
| New - 2a | New | 0.07 |
| New - 2b | New | 0.09 |
| New - 3a | New | 0.07 |
| New - 3b | New | 0.05 |
| Worn - 1a^{a} | Worn | N/A |
| Worn - 1b^{a} | Worn | N/A |
| Worn - 2a | Worn | 0.07 |
| Worn - 2b | Worn | 0.08 |
| Worn - 3a | Worn | 0.08 |
| Worn - 3b | Worn | 0.10 |

| Experimental (No Post-Heat) | | |
|---|---|---|
| RD - 1a (Disc #3) | RD™ Only | 0.05 |
| RD - 1b " | RD™ Only | 0.06 |
| RD - 2a " | RD™ Only | 0.045 |
| RD - 2b " | RD™ Only | 0.05 |
| RD - 3a^{b} (Disc #4) | RD™ Only | N/A |
| RD - 3b^{b} " | RD™ Only | N/A |

| Experimental (With Post-Heat) | | |
|---|---|---|
| HT - 1a (Disc #3) | (1800°C) Heat Treat | 0.07 |
| HT - 1b " | (1800°C) Heat Treat | 0.06 |
| HT - 2a " | (2100°C) Heat Treat | 0.03 |
| HT - 2b (Disc #3) | (2100°C) Heat Treat | 0.03 |
| HT - 3a (Disc #4) | (2400°C) Heat Treat | 0.17 |
| HT - 3b " | (2400°C) Heat Treat | 0.34 |

| | | |
|---|---|---|
| a. Sample delaminated during testing. | | |
| b. Exceeded maximum test temperature. | | |

| **Coefficient of Friction for Each Specimen** **Pair for Last Five Braking Cycles**^{**a**} | | | | | | |
|---|---|---|---|---|---|---|
| **Rotor Specimen** | **6** | **7** | **8** | **9** | **10** | **Mean** |
| New - 1a, 1b | 0.32 | 0.32 | 0.30 | 0.30 | 0.31 | 0.31 |
| New - 2a, 2b | 0.31 | 0.31 | 0.29 | 0.27 | 0.28 | 0.29 |
| New - 3a, 3b | 0.29 | 0.31 | 0.26 | 0.27 | 0.26 | 0.28 |
| Worn - 1a, 1b | n/a | n/a | n/a | n/a | n/a | n/a |
| Worn - 2a, 2b | 0.24 | 0.23 | 0.23 | 0.24 | 0.22 | 0.23 |
| Worn - 3a, 3b | 0.24 | 0.25 | 0.25 | 0.23 | 0.23 | 0.24 |

| Experimental (No Post-Heat) | | | | | | |
|---|---|---|---|---|---|---|
| RD - 1a, 1b (Disc #3) | 0.29 | 0.29 | 0.27 | 0.28 | 0.28 | 0.28 |
| RD - 2a, 2b (Disc #3) | 0.33 | 0.30 | 0.31 | 0.31 | 0.30 | 0.31 |
| RD - 3a, 3b (Disc #4) | n/a | n/a | n/a | n/a | n/a | n/a |

| Experimental (With Post-Heat) | | | | | | |
|---|---|---|---|---|---|---|
| HT - 1800°C- 1a, 1b (Disc #3) | 0.33 | 0.33 | 0.32 | 0.33 | 0.34 | 0.33 |
| HT - 2100°C- 2a, 2b (Disc #3) | 0.29 | 0.29 | 0.29 | 0.28 | 0.27 | 0.28 |
| HT - 2400°C- 3a, 3b (Disc #4) | 0.40 | 0.40 | 0.38 | 0.35 | 0.34 | 0.37 |

| | | | | | | |
|---|---|---|---|---|---|---|
| a. The data gathered throughout each test cycle included normal force, torque, and temperature. The friction force, F, is related to the friction coefficient, µ, and normal force, N, by the following expression: F = µN. The torque imposed on the disc is given by the friction force, multiplied by the mean radius of the disc: T = Frₘ. Solving for µ gives: µ = T/Nrₘ. In a representative test cycle, the maximum temperature occurred at approximately 7 seconds into the test cycle. At this time interval, the torque imposed on the stationary disc was 0.4 m-kg (35 in-lb). Substituting this value into the equation, along with the recorded normal force of 112 kg (247 lb) and a mean radius of 13,3 mm (0.525 inches) for the sample, we calculated a friction coefficient of 0.27. | | | | | | |

The results show that exposing a half thickness worn F-16 aircraft brake to the refurbishment method herein will significantly increase the wear and friction characteristics of the brake. In these tests, use of the refurbishment method, even without post-heat treatment, gave wear properties meeting, or exceeding those of a new or a traditionally refurbished brake, without jeopardizing friction coefficients.

The wear data in Table 2 show that samples processed using a three hour densification cycle had 25% less average wear than that of the new brake samples. Table 2 data also show the results of post-heat treatment cycles on the samples. This data, though limited, suggests that exposing the brakes to elevated temperatures after refurbishment will modify both the wear characteristics and the friction coefficients of the material. The data taken from the pair of refurbished specimens which were post heat treated at 2100°C showed 56% less wear and had the same average friction coefficient as the new brake samples.

Run conditions other than those exemplified herein may be used to refurbish worn brakes and appropriate conditions may be selected by the practitioner to accommodate variables in brake components, apparatus size and design, liquid carbon-precursor, and process conditions. Run conditions may be adjusted to accommodate simultaneous processing of multiple carbon brake component(s), with or without the use of a susceptor. The only requirement is that the conditions must yield a carbon/carbon composite microstructure characterized by friction coefficient, wear and thermal properties which are adequate for aircraft brake operations, and the chemical vapor deposition process must be completed rapidly, i.e., in less than 48 hours, preferably less than 24 hours.

Accordingly, the invention should be limited only by the scope of the appended claims.

## Claims

1. A method of refurbishing a worn carbon brake component for an aircraft, the component having pores defined by interior regions, including at least one geometric center region, and an exterior surface, the method comprising the steps of:
providing a reactor containing a liquid carbon-precursor and at least one internal induction coil;
placing the worn carbon brake component in the liquid carbon-precursor contained within the reactor;
inductively heating the interior regions of the worn carbon brake component to a temperature above the decomposition temperature of the liquid carbon-precursor, thereby effecting formation of a vapour from the liquid carbon pre-cursor and infiltration of the vapour into the interior regions and deposition of pyrolytic carbon within the interior regions, until the worn carbon brake component has a density of at least 1.85 g/cc and a non-isotropic CVD microstructure, and
wherein the inductively heating step may be continuous or interrupted by periodic cooling by at least 10°C.

2. The method of claim 1, wherein the inductively heating step is for a period of time until the worn carbon brake component has a density of at least 1.9 g/cc.

3. The method of claim 1, wherein the reactor is coupled to a condenser for condensing vaporized liquid carbon-precursor and returning the liquid carbon-precursor to the reactor.

4. The method of claim 1, wherein the method additionally comprises the step of heating the refurbished carbon brake component to a temperature of about 1500 to 2400°C, following completion of chemical vapor deposition.

5. The method of claim 1, wherein the worn carbon brake component is fully refurbished by inductively heating for 2.0 to 3.5 hours to an internal temperature of 950 to 1100°C and an external temperature of 800 to 1100°C in cyclohexane.

6. The method of claim 1, further comprising the steps of
a) setting an initial frequency and power to the induction coil, the initial frequency and power being effective to accumulate sufficient heat at a geometric center region of the worn carbon brake component to reach a temperature sufficient to cause pyrolysis of the vapor and deposition preferentially in the pores located in the geometric center region of the worn carbon brake component;
b) supplying an initial quantity of power to the induction coil at the initial frequency sufficient to heat the geometric center region of the worn carbon brake component to a temperature adequate for densifying the geometric center region without simultaneously densifying other interior regions and the exterior surface of the worn carbon brake component;
c) following densification of the geometric center region of the worn carbon brake component, supplying a quantity of power to the induction coil at one or more frequency setting(s), the quantity of power and frequency setting being effective to accumulate sufficient heat in interior regions of the worn carbon brake component to cause pyrolysis of the vapor and deposition preferentially in the pores located in the interior regions of the worn carbon brake component adjacent to the geometric center region; and
d) adjusting the quantity of power supplied to the induction coil at one or more frequency setting(s), the quantity of power and frequency setting being effective to progressively densify the interior regions of the worn carbon brake component in a radial direction outwards from the geometric center region and through a thickness of the worn carbon brake component.

7. The method of claim 1, wherein the chemical vapor deposition step is carried out at a pressure of one-half to four atmospheres.

8. The method of claim 1, wherein the liquid carbon-precursor comprises at least one C5 to C9 liquid hydrcarbon.

9. The method of claim 8, wherein the liquid carbon-precursor is selected from the group consisting of cyclopentane, hexane, cyclohexene, 1-hexene, cyclohexane, gasoline, methyl cyclohexane, benzene and toluene, or a combination thereof.

10. The method of claim 1, wherein the friction coefficient of the refurbished carbon brake component is at least equal to 0.27.

11. The method of claim 1, wherein the worn carbon brake component is selected from the group consisting of carbon rotors, carbon stators, carbon end plates and carbon pressure plates.

12. A method of refurbishing a worn carbon brake component for an aircraft, the component having pores defined by interior regions, including at least one geometric center region, and an exterior surface, the method comprising the steps of:
providing a reactor containing a liquid carbon-precursor and at least one set of electrodes with connectors adapted to make electrical contact to the worn carbon brake component, and providing at least one power source for electrically heating the worn carbon brake component;
placing the worn carbon brake component in the liquid carbon-precursor contained within the reactor, supplying sufficient current to the worn carbon brake component to resistively heat the interior regions of the worn carbon brake component to a temperature above the decomposition temperature of the liquid carbon-precursor, thereby effecting formation of a vapour from the liquid carbon pre-cursor and infiltration of the vapour into the interior regions and deposition of pyrolytic carbon within the interior regions, until the worn carbon brake component has a density of at least 1.85 g/cc and a non-isotropic CVD microstructure.
wherein the supplying sufficient current step may be continuous or interrupted to periodically cool the interior regions of the worn carbon brake component by at least 10°C.

13. The method of claim 12, wherein the resistive heating step is for a period of time until the worn carbon brake component has a density of at least 1.9 g/cc.

14. The method of claim 12, wherein the reactor is coupled to at least one condenser for condensing vaporized liquid carbon-precursor and returning the liquid carbon-precursor to the reactor.

15. The method of claim 12, wherein the method additionally comprises the step of heating the refurbished carbon brake component to a temperature of about 1500 to 2400°C, following completion of chemical vapor deposition.

16. The method of claim 12, wherein the worn carbon brake component is fully refurbished by heating for 2.0 to 3.5 hours to an internal temperature of 950 to 1100°C and an external temperature of 800 to 1100°C in cyclohexane.

17. The method of claim 12, further comprising the steps:
a) setting an initial electrical current to a set of electrodes, the initial electrical current being effective to accumulate sufficient heat in interior regions of the worn carbon brake component to cause pyrolysis of the vapor and deposition preferentially in the pores located in the interior regions of the worn carbon brake component, including the geometric center region; and
b) adjusting the quantity of electrical current supplied to the set of electrodes to progressively densify the interior regions of the worn carbon brake component in a radial direction outwards from the geometric center region of the worn carbon brake component.

18. The method of claim 12, wherein the chemical vapor deposition step is carried out at a pressure of one-half to four atmospheres.

19. The method of claim 12, wherein the liquid carbon-precursor comprises at least one C5 to C9 liquid hydrocarbon.

20. The method of claim 19, wherein the liquid carbon-precursor is selected from the group consisting of cyclopentane, hexane, cyclohexene, 1-hexene, cyclohexane, gasoline, methyl cyclohexane, benzene and toluene, or a combination thereof.

21. The method of claim 12, wherein the friction coefficient of the refurbished carbon brake component is at least 0.27.

22. The method of claim 12, wherein all or part of the worn carbon brake component is heated with means comprising an inductive heating means and the resistive heating means.

23. The method of claim 22, further comprising the steps:
a) setting an initial frequency and power to an induction coil, the initial frequency and power being effective to accumulate sufficient heat at a geometric center region of the worn carbon brake component to reach a temperature adequate to pyrolyze the vapor and deposit carbon preferentially in the pores located in the geometric center region of the worn carbon brake component;
b) supplying an initial quantity of power to the induction coil at the initial frequency sufficient to densify the geometric center region of the worn carbon brake component without simultaneously densifying other interior regions and the exterior surface of the worn carbon brake component;
c) following densification of the geometric center region of the worn carbon brake component supplying a quantity of power to the induction coil at one or more frequency settings the quantity of power and frequency setting being effective to accumulate sufficient heat in interior regions of the worn carbon brake component to cause pyrolysis of the vapor and deposition preferentially in the pores located in the interior regions of the worn carbon brake component adjacent to the geometric center region;
d) providing electrical current to the worn carbon brake component through the electrodes to resistively heat the worn carbon brake component; and
e) adjusting the quantity of electrical current and the quantity of power supplied to the induction coil at one or more frequency settings, the quantity of electrical current and the quantity of power and frequency setting being effective to progressively densify the interior regions of the worn carbon brake component in a radial direction outwards from the geometric center region and through a thickness of the worn carbon brake component.

## Patentansprüche

1. Verfahren zur Wiederertüchtigung einer verschlissenen Bremskomponente aus Kohlenstoff für ein Flugzeug, wobei die Komponente Poren hat, die durch Innenbereiche einschließlich eines geometrisch mittleren Bereichs und einer Außenfläche abgegrenzt werden, wobei das Verfahren folgende Schritte beinhaltet:
Bereitstellen eines Reaktors, der einen flüssigen Kohlenstoffvorläufer und mindestens eine interne Induktionsspule enthält;
Einsetzen der verschlissenen Bremskomponente aus Kohlenstoff in den flüssigen Kohlenstoffvorläufer, der im Reaktor enthalten ist;
induktive Erwärmung der Innenbereiche der verschlissenen Bremskomponente aus Kohlenstoff bis zu einer Temperatur, die oberhalb der Zersetzungstemperatur des flüssigen Kohlenstoffvorläufers liegt, sowie Infiltration des Dampfes in Innenbereiche und Abscheiden pyrolytischen Kohlenstoffs innerhalb der Innenbereiche, bis die verschlissene Bremskomponente aus Kohlenstoff eine Dichte von mindestens 1,85 g/cc und eine nicht isotropische CVD-Mikrostruktur hat, und
wobei der induktive Erwärmungsschritt kontinuierlich sein oder durch periodische Abkühlung um mindestens 10°C unterbrochen werden kann.

2. Verfahren nach Anspruch 1, wobei der induktive Erwärmungsschritt solange andauert, bis die verschlissene Bremskomponente aus Kohlenstoff eine Dichte von mindestens 1.9 g/cc hat.

3. Verfahren nach Anspruch 1, wobei der Reaktor an einen Kondensator zur Verdichtung des verdampften flüssigen Kohlenstoffvorläufers und zur Rückführung des flüssigen Kohlenstoffvorläufers in den Reaktor gekoppelt ist.

4. Verfahren nach Anspruch 1, wobei das Verfahren zusätzlich den Schritt der Erwärmung der wieder ertüchtigten Bremskomponente aus Kohlenstoff auf eine Temperatur von ca. 1500 bis 2400°C nach Abschluss des chemischen Abscheidens aus der Gasphase enthält.

5. Verfahren nach Anspruch 1, wobei die verschlissene Bremskomponente aus Kohlenstoff durch Erwärmung über einen Zeitraum von 2,0 bis 3,5 Stunden auf eine Innentemperatur von 950 bis 1100°C und eine Außentemperatur von 800 bis 1110°C in Cyclohexan vollständig wiederertüchtigt wird.

6. Verfahren nach Anspruch 1, zusätzlich folgende Schritte enthaltend:
a) Einstellen einer anfänglichen Frequenz und einer Leistungsversorgung der Induktionsspule, wobei die anfängliche Frequenz und die Leistung bewirken, dass eine ausreichende Wärmemenge in einem geometrisch mittleren Bereich der verschlissenen Bremskomponente aus Kohlenstoff erreicht wird, die ausreicht, um die Pyrolyse des Dampfes und das Abscheiden vorzugsweise in den Poren auszulösen, die sich in dem geometrisch mittleren Bereich der verschlissenen Bremskomponente aus Kohlenstoff befinden;
b) Zufuhr einer anfänglichen Energiemenge zu der Induktionsspule bei der anfänglichen Frequenz, die ausreicht, um den geometrisch mittleren Bereich der verschlissenen Bremskomponente auf eine Temperatur zu erwärmen, die zum Verdichten des geometrisch mittleren Bereichs ohne gleichzeitige Verdichtung anderer Innenbereiche und der Außenfläche der verschlissenen Bremskomponente aus Kohlenstoff ausreicht;
c) nach der Verdichtung des geometrisch mittleren Bereichs der verschlissenen Bremskomponente aus Kohlenstoff Zufuhr einer Energiemenge zu der Induktionsspule bei einer oder mehreren Frequenzeinstellung(en), wobei die Energiemenge und die Frequenzeinstellung bewirken, dass in den Innenbereichen der verschlissenen Bremskomponente aus Kohlenstoff eine ausreichende Wärmemenge gespeichert wird, um die Pyrolyse des Dampfes und das Abscheiden vorzugsweise in den Poren auszulösen, die sich in den Innenbereichen der verschlissenen Bremskomponente aus Kohlenstoff neben dem geometrisch mittleren Bereich befinden;
und
d) Einstellen der Energiemenge, die der Induktionsspule bei einer oder mehreren Frequenzeinstellung(en) zugeführt wird, wobei die Energiemenge und die Frequenzeinstellung bewirken, dass die Innenbereiche der verschlissenen Bremskomponente aus Kohlenstoff von dem geometrisch mittleren Bereich aus in radialer Richtung nach außen und durch eine Dicke der verschlissenen Bremskomponente aus Kohlenstoff schrittweise verdichtet werden.

7. Verfahren nach Anspruch 1, wobei der Schritt des chemischen Abscheidens bei einem Druck von einer halben bis zu vier Atmosphären durchgeführt wird.

8. Verfahren nach Anspruch 1, wobei der flüssige Kohlenstoffvorläufer mindestens einen flüssigen C5- bis C9-Kohlenwasserstoff umfasst.

9. Verfahren nach Anspruch 8, wobei der flüssige Kohlenstoffvorläufer aus einer Gruppe ausgewählt wird, die Cyclopentan, Hexan, Cyclohexen, 1-Hexen, Cyclohexen, Benzin, Methylcyclohexan, Benzol und Toluol, oder eine Kombination von diesen beinhaltet.

10. Verfahren nach Anspruch 1, wobei der Reibungskoeffizient der wiederertüchtigten Bremskomponente aus Kohlenstoff mindestens 0,27 beträgt.

11. Verfahren nach Anspruch 1, wobei die verschlissene Bremskomponente aus Kohlenstoff aus einer Gruppe ausgewählt wird, die Kohlenstoffrotoren, Kohlenstoffständer, Kohlenstoffendplatten und Kohlenstoffdruckplatten beinhaltet.

12. Verfahren zur Wiederertüchtigung einer verschlissenen Bremskomponente aus Kohlenstoff für ein Flugzeug, wobei die Komponente Poren hat, die von Innenbereichen einschließlich mindestens eines geometrisch mittleren Bereichs und einer Außenfläche abgegrenzt werden, und wobei das Verfahren folgende Schritte umfasst:
Bereitstellen eines Reaktors, der einen flüssigen Kohlenstoffvorläufer und mindestens einen Satz Elektroden mit Verbindem umfasst, um einen elektrischen Kontakt zu der verschlissenen Bremskomponente aus Kohlenstoff herzustellen, und der zumindest eine Energiequelle für die elektrische Erwärmung der verschlissenen Bremskomponente aus Kohlenstoff zur Verfügung stellt;
Einsetzen der verschlissenen Bremskomponente aus Kohlenstoff in den flüssigen Kohlenstoffvorläufer, der im Reaktor enthalten ist, die Zufuhr einer ausreichenden Strommenge an die verschlissene Bremskomponente aus Kohlenstoff, um die Innenbereiche der verschlissenen Bremskomponente aus Kohlenstoff durch Widerstandserwärmung auf eine Temperatur oberhalb der Zersetzungstemperatur des flüssigen Kohlenstoffvorläufers zu erwärmen und dabei die Bildung eines Dampfes aus dem flüssigen Kohlenstoffvorläufer sowie die Infiltration des Dampfes in die Innenbereiche und das Abscheiden pyrolytischen Kohlenstoffs innerhalb der Innenbereiche zu bewirken, bis die verschlissene Bremskomponente aus Kohlenstoff eine Dichte von mindestens 1,85 g/c.c. und eine nicht-isotropische CVD-Mikrostruktur von mindestens 1,85 g/c.c. hat,
wobei der Schritt der Zufuhr einer ausreichenden Strommenge kontinuierlich ist oder unterbrochen wird, um die Innenbereiche der verschlissenen Bremskomponente aus Kohlenstoff um mindestens 10°C periodisch abzukühlen.

13. Verfahren nach Anspruch 12, wobei der Widerstandserwärmungsschritt solange andauert, bis die verschlissene Bremskomponente aus Kohlenstoff eine Dichte von mindestens 1.9 g/c.c. hat.

14. Verfahren nach Anspruch 12, wobei der Reaktor an einen Kondensator zum Verdichten des verdampften flüssigen Kohlenstoffvorläufers und zur Rückführung des flüssigen Kohlenstoffvoriäufers in den Reaktor gekoppelt ist.

15. Verfahren nach Anspruch 12, wobei das Verfahren zusätzlich den Schritt der Erwärmung der wiederertüchtigten Bremskomponente aus Kohlenstoff auf eine Temperatur von ca. 1500 bis 2400°C nach dem Abschluss des chemischen Abscheidens beinhaltet.

16. Verfahren nach Anspruch 12, wobei die verschlissene Bremskomponente aus Kohlenstoff durch Erwärmung über einen Zeitraum von 2,0 bis 3,5 Stunden auf eine Innentemperatur von 950 bis 1100°C und eine Außentemperatur von 800 bis 1100°C in Cyclohexan vollständig wiederertüchtigt wird.

17. Verfahren nach Anspruch 12, wobei das Verfahren zusätzlich die Schritte enthält:
a) Einstellen einer anfänglichen Stromzufuhr zu einem Satz Elektroden, wobei die anfängliche Stromzufuhr bewirkt, dass eine ausreichende Wärmemenge in dem Innenbereichen der verschlissenen Bremskomponente aus Kohlenstoff angesammelt wird, um die Pyrolyse des Dampfes und das Abscheiden vorzugsweise in den Poren auszulösen, die sich in den Innenbereichen der verschlissenen Bremskomponente aus Kohlenstoff einschließlich des geometrisch mittleren Bereichs befinden; und
b) Einstellen der Menge des elektrischen Stroms, der dem Satz von Elektroden zugeführt wird, um die Innenbereiche der verschlissenen Bremskomponente aus Kohlenstoff von dem geometrisch mittleren Bereich der verschlissenen Bremskomponente aus Kunststoff aus nach außen in radialer Richtung schrittweise zu verdichten.

18. Verfahren nach Anspruch 12, wobei der Schritt des chemischen Abscheidens bei einem Druck von einer halben bis vier Atmosphären durchgeführt wird.

19. Verfahren nach Anspruch 12, wobei der flüssige Kohlenstoffvorläufer mindestens einen flüssigen C5- bis C9-Kohlenwassserstoff enthält.

20. Verfahren nach Anspruch 19, wobei der flüssige Kohlenstoffvorläufer aus einer Gruppe ausgesucht wird, die Cyclopentan, Hexan, Cyclohexen, 1-Hexen, Cyclohexan, Benzin, Methylcyclohexan, Benzol und Toluol, oder eine Kombination von diesen beinhaltet.

21. Verfahren nach Anspruch 12, wobei der Reibungskoeffizient der wiederertüchtigten Bremskomponente aus Kohlenstoff mindestens 0,27 beträgt.

22. Verfahren nach Anspruch 12, wobei die ganze oder ein Teil der Kohlenstoffbremskomponente mit Mitteln aufgewärmt wird, die Induktionserwärmungsmittel und die Widerstandserwärmungsmittel beinhalten.

23. Verfahren nach Anspruch 22, das zusätzlich die Schritte umfasst:
a) Einstellen einer anfänglichen Frequenz und einer Leistungsversorgung einer Induktionsspule, wobei die anfängliche Frequenz und die Leistung bewirken, dass ausreichende Wärme in einem geometrisch mittleren Bereich der verschlissenen Bremskomponente aus Kohlenstoff gespeichert wird, um eine Temperatur zu erreichen, die ausreicht, um den Dampf durch Pyrolyse zu erzeugen und Kohlenstoff vorzugsweise in den Poren abzuscheiden, die sich in dem geometrisch mittleren Bereich der verschlissenen Bremskomponente aus Kohlenstoff befinden;
b) Zufuhr einer anfänglichen Strommenge zu der Induktionsspule bei der anfänglichen Frequenz, die ausreicht, um den geometrisch mittleren Bereich der verschlissenen Kohlenstoffbremskomponente zu verdichten, ohne gleichzeitig andere Innenbereiche und die Außenfläche der verschlissenen Bremskomponente aus Kohlenstoff zu verdichten;
c) nach der Verdichtung des geometrisch mittleren Bereichs der verschlissenen Bremskomponente aus Kohlenstoff Zufuhr einer Energiemenge zu der Induktionsspule bei einer oder mehreren Frequenzeinstellung(en), wobei die Energiemenge und die Frequenzeinstellung bewirken, dass ausreichend Wärme in den Innenbereichen der verschlissenen Bremskomponente aus Kohlenstoff gespeichert wird, um die Pyrolyse des Dampfes und das Abscheiden vorzugsweise in den Poren auszulösen, die sich in den Innenbereichen der verschlissenen Bremskomponente aus Kohlenstoff neben dem geometrisch mittleren Bereich befinden;
d) Zufuhr elektrischen Stroms zu der verschlissenen Bremskomponente aus Kohlenstoff durch die Elektroden, um die verschlissene Bremskomponente aus Kohlenstoff durch Widerstandserwärmung zu erwärmen; und
e) Einstellen der elektrischen Strommenge und der Energiemenge, die der Induktionsspule bei einer oder mehreren Frequenzeinstellung(en) zugeführt werden, wobei die Menge an elektrischem Strom und die Energiemenge und die Frequenzeinstellung bewirken, dass die Innenbereiche der verschlissenen Bremskomponente aus Kohlenstoff vom geometrisch mittleren Bereich aus nach außen in radialer Richtung und durch eine Dicke der verschlissenen Bremskomponente aus Kohlenstoff hindurch verdichtet werden.

## Revendications

1. Procédé de remise à neuf d'un élément de frein usé en carbone pour avion, l'élément ayant des pores définis par des régions intérieures, comprenant au moins une région centrale géométrique, et une surface extérieure, le procédé comprenant les étapes consistant à :
fournir un réacteur contenant un précurseur liquide de carbone et au moins une bobine d'induction interne ;
placer l'élément de frein usé en carbone dans le précurseur liquide de carbone contenu dans le réacteur ;
chauffer par induction les régions intérieures de l'élément de frein usé en carbone à une température supérieure à la température de décomposition du précurseur liquide de carbone, entraînant ainsi la formation d'une vapeur à partir du précurseur liquide de carbone, l'infiltration de la vapeur dans les régions intérieures et le dépôt de carbone pyrolytique dans les régions intérieures, jusqu'à ce que l'élément de frein usé en carbone ait une densité d'au moins 1,85 g/cc et une microstructure de dépôt chimique en phase gazeuse non isotropique, et
dans lequel l'étape de chauffage par induction peut être continue ou interrompue par un refroidissement périodique d'au moins 10°C.

2. Procédé selon la revendication 1, dans lequel l'étape de chauffage par induction se fait pendant une durée permettant que l'élément de frein usé en carbone atteigne une densité d'au moins 1,9 g/cc.

3. Procédé selon la revendication 1, dans lequel le réacteur est relié à un condenseur pour condenser le précurseur liquide de carbone vaporisé et renvoyer le précurseur liquide de carbone dans le réacteur.

4. Procédé selon la revendication 1, dans lequel le procédé comprend en outre une étape de chauffage de l'élément de frein en carbone remis à neuf à une température d'environ 1500 à 2400°C, après l'achèvement du dépôt chimique en phase gazeuse.

5. Procédé selon la revendication 1, dans lequel l'élément de frein usé en carbone est complètement remis à neuf par chauffage par induction pendant 2,0 à 3,5 heures à une température interne de 950 à 1100°C et une température externe de 800 à 1100°C dans du cyclohexane.

6. Procédé selon la revendication 1, comprenant en outre les étapes consistant à
a) fixer une fréquence et une puissance initiales appliquées à la bobine d'induction, les fréquence et puissance initiales étant telles qu'elles permettent d'accumuler une chaleur suffisante au niveau d'une région centrale géométrique de l'élément de frein usé en carbone pour atteindre une température suffisante pour entraîner la pyrolyse de la vapeur et le dépôt préférentiellement dans les pores situés dans la région centrale géométrique de l'élément de frein usé en carbone ;
b) fournir une puissance initiale à la bobine d'induction à la fréquence initiale suffisante pour chauffer la région centrale géométrique de l'élément de frein usé en carbone à une température adéquate pour densifier la région centrale géométrique sans simultanément densifier les autres régions intérieures et la surface extérieure de l'élément de frein usé en carbone ;
c) après la densification de la région centrale géométrique de l'élément de frein usé en carbone, fournir une puissance à la bobine d'induction à une ou plusieurs valeurs de réglage de fréquence, la puissance et la valeur de réglage de fréquence étant telles qu'elles permettent d'accumuler une chaleur suffisante dans des régions intérieures de l'élément de frein usé en carbone pour entraîner la pyrolyse de la vapeur et le dépôt préférentiellement dans les pores situés dans les régions intérieures de l'élément de frein usé en carbone adjacentes à la région centrale géométrique ; et
d) régler la puissance fournie à la bobine d'induction à une ou plusieurs valeurs de réglage de fréquence, la puissance et la valeur de réglage de fréquence étant telles qu'elles permettent de densifier progressivement les régions intérieures de l'élément de frein usé en carbone dans une direction radiale vers l'extérieur de la région centrale géométrique et à travers une épaisseur de l'élément de frein usé en carbone.

7. Procédé selon la revendication 1, dans lequel l'étape de dépôt chimique en phase gazeuse est réalisée à une pression d'une demie à quatre atmosphères.

8. Procédé selon la revendication 1, dans lequel le précurseur liquide de carbone comprend au moins un hydrocarbure liquide C5 à C9.

9. Procédé selon la revendication 8, dans lequel le précurseur liquide de carbone est choisi dans le groupe constitué par le cyclopentane, l'hexane, le cyclohexène, le 1-hexène, le cyclohexane, l'essence, le méthyl cyclohexane, le benzène et le toluène, ou une combinaison de ceux-ci.

10. Procédé selon la revendication 1, dans lequel le coefficient frottement de l'élément de frein en carbone remis à neuf est au moins égal à 0,27.

11. Procédé selon la revendication 1, dans lequel l'élément de frein usé en carbone est choisi dans le groupe constitué par des disques rotors en carbone, des disques stators en carbone, des plaques d'extrémité en carbone et des plaques de pression en carbone.

12. Procédé de remise à neuf d'un élément de frein usé en carbone pour avion, l'élément ayant des pores définis par des régions intérieures, comprenant au moins une région centrale géométrique, et une surface extérieure, le procédé comprenant les étapes consistant à :
fournir un réacteur contenant un précurseur liquide de carbone et au moins un jeu d'électrodes avec des connecteurs adaptés pour entrer en contact électrique avec l'élément de frein usé en carbone, et fournir au moins une source d'énergie pour chauffer électriquement l'élément de frein usé en carbone ;
placer l'élément de frein usé en carbone dans le précurseur liquide de carbone contenu dans le réacteur, fournir un courant suffisant à l'élément de frein usé en carbone pour réaliser un chauffage résistif des régions intérieures de l'élément de frein usé en carbone à une température supérieure à la température de décomposition du précurseur liquide de carbone, entraînant ainsi la formation d'une vapeur à partir du précurseur liquide de carbone, l'infiltration de la vapeur dans les régions intérieures et le dépôt de carbone pyrolytique dans les régions intérieures, jusqu'à ce que l'élément de frein usé en carbone atteigne une densité d'au moins 1,85 g/cc et une microstructure de dépôt chimique en phase gazeuse non isotropique,
dans lequel l'étape de fourniture d'un courant suffisant peut être continue ou interrompue pour refroidir périodiquement les régions intérieures de l'élément de frein usé en carbone d'au moins 10°C.

13. Procédé selon la revendication 12, dans lequel l'étape de chauffage résistif est réalisé pendant une durée telle que l'élément de frein usé en carbone atteigne une densité d'au moins 1,9 g/cc.

14. Procédé selon la revendication 12, dans lequel le réacteur est relié à au moins un condenseur pour condenser le précurseur liquide de carbone vaporisé et renvoyer le précurseur liquide de carbone dans le réacteur.

15. Procédé selon la revendication 12, comprenant en outre une étape de chauffage de l'élément de frein en carbone remis à neuf à une température d'environ 1500 à 2400°C, après la fin du dépôt chimique en phase gazeuse.

16. Procédé selon la revendication 12, dans lequel l'élément de frein usé en carbone est complètement remis à neuf par chauffage pendant 2,0 à 3,5 heures à une température interne de 950 à 1100°C et une température externe de 800 à 1100°C dans du cyclohexane.

17. Procédé selon la revendication 12, comprenant en outre les étapes consistant à :
a) appliquer un courant électrique initial à un jeu d'électrodes, le courant électrique initial étant tel qu'il permette d'accumuler une chaleur suffisante dans des régions intérieures de l'élément de frein usé en carbone pour entraîner la pyrolyse de la vapeur et le dépôt préférentiellement dans les pores situés dans les régions intérieures de l'élément de frein usé en carbone, comprenant la région centrale géométrique ; et
b) régler le courant électrique fourni au jeu d'électrodes pour progressivement densifier les régions intérieures de l'élément de frein usé en carbone dans une direction radiale vers l'extérieur de la région centrale géométrique de l'élément de frein usé en carbone.

18. Procédé selon la revendication 12, dans lequel l'étape de dépôt chimique en phase gazeuse est réalisée à une pression d'une demie à quatre atmosphères.

19. Procédé selon la revendication 12, dans lequel le précurseur liquide de carbone comprend au moins un hydrocarbure liquide C5 à C9.

20. Procédé selon la revendication 19, dans lequel le précurseur liquide de carbone est choisi dans le groupe constitué par le cyclopentane, l'hexane, le cyclohexène, le 1-hexène, le cyclohexane, l'essence, le méthyl cyclohexane, le benzène et le toluène, ou une combinaison de ceux-ci.

21. Procédé selon la revendication 12, dans lequel le coefficient de frottement de l'élément de frein en carbone remis à neuf est au moins 0,27.

22. Procédé selon la revendication 12, dans lequel tout ou une partie de l'élément de frein usé en carbone est chauffé avec des moyens comprenant un moyen de chauffage par induction et le moyen de chauffage résistif.

23. Procédé selon la revendication 22, comprenant en outre les étapes consistant à :
a) fixer une fréquence et une puissance initiales appliquées à une bobine d'induction, les fréquence et puissance initiales étant telles qu'elles permettent d'accumuler une chaleur suffisante au niveau d'une région centrale géométrique de l'élément de frein usé en carbone pour atteindre une température adéquate pour pyrolyser la vapeur et déposer le carbone préférentiellement dans les pores situés dans la région centrale géométrique de l'élément de frein usé en carbone ;
b) fournir une puissance initiale à la bobine d'induction à la fréquence initiale suffisante pour densifier la région centrale géométrique de l'élément de frein usé en carbone sans simultanément densifier d'autres régions intérieures et la surface extérieure de l'élément de frein usé en carbone ;
c) après la densification de la région centrale géométrique de l'élément de frein usé en carbone, fournir une puissance à la bobine d'induction à une ou plusieurs valeurs de réglage de fréquence, la puissance et la valeur de réglage de fréquence étant telles qu'elles permettent d'accumuler une chaleur suffisante dans des régions intérieures de l'élément de frein usé en carbone pour entraîner la pyrolyse de la vapeur et le dépôt préférentiellement dans les pores situés dans les régions intérieures du composant de frein au carbone usé adjacentes à la région centrale géométrique ;
d) appliquer un courant électrique à l'élément de frein usé en carbone par l'intermédiaire des électrodes pour réaliser un chauffage résistif de l'élément de frein usé en carbone ; et
e) régler le courant électrique et la puissance fournis à la bobine d'induction à une ou plusieurs valeurs de réglage de fréquence, le courant électrique, la puissance et la valeur de réglage de fréquence étant telles qu'elles permettent de densifier progressivement les régions intérieures de l'élément de frein usé en carbone dans une direction radiale vers l'extérieur de la région centrale géométrique et à travers une épaisseur de l'élément de frein usé en carbone.
